(19)

Europäisches
Patentamt
European
Patent Office
Office européen
des brevets

(11)  **EP 1 674 925 B1**

(12)  **EUROPEAN PATENT SPECIFICATION**

(45) Date of publication and mention
of the grant of the patent:
**02.07.2008 Bulletin 2008/27**

(51) Int Cl.:
**G02F 1/1362** (2006.01)

(21) Application number: **05023688.4**

(22) Date of filing: **28.10.2005**

(54) **Liquid crystal displays with improved gray-scale**

Flüssigkristallanzeigen mit verbesserter Graustufe

Affichages à cristaux liquides avec niveaux de gris améliorés

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **23.12.2004 US 21049**

(43) Date of publication of application:
**28.06.2006 Bulletin 2006/26**

(73) Proprietor: **AU Optronics Corporation
Hsin-Chu 300 (TW)**

(72) Inventor: **Chiu, Chun-Chang
Tao Yuan Shien (TW)**

(74) Representative: **Hruschka, Jürgen et al
Habermann, Hruschka & Schnabel,
Patentanwälte,
Montgelasstrasse 2
81679 München (DE)**

(56) References cited:
**EP-A- 0 438 138          US-A- 5 717 474
US-A1- 2003 025 661          US-A1- 2004 094 766**

• **SARMA K.R. ET AL: 'ACTIVE-MATRIX LCDS
USING GRAY-SCALE IN HALFTONE METHODS'
SID INTERNATIONAL SYMPOSIUM vol. 20, 16
May 1989, pages 148 - 150, XP000076853**

## Description

The invention relates to active liquid crystal displays, and more particularly to liquid crystal displays with improved gray-scale.

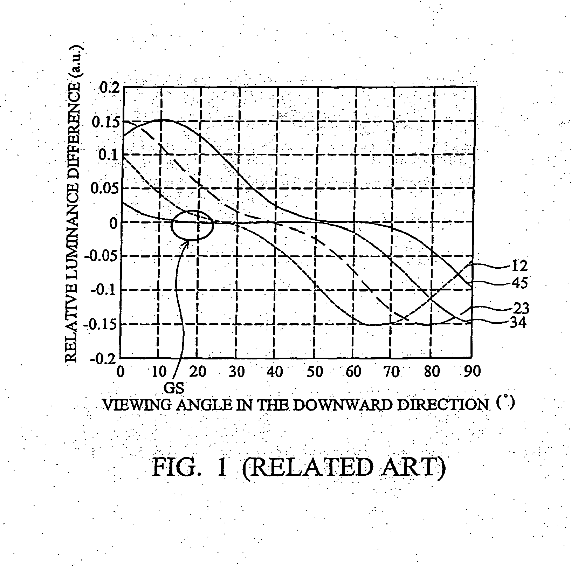

In a conventional TN (twisted nematic) mode liquid crystal display, gray-scale inversion in half tones of gray is an issue for viewing angle characteristics. In TN mode liquid crystal displays, gray-scale inversions do not easily occur in the upward and horizontal directions, but they easily occur in the downward direction. Fig. 1 shows viewing-angle dependence of relative luminance difference in the normally white mode for a conventional TN mode liquid crystal display in the downward direction. Curves 12, 23, 34 and 45 show the viewing-angle dependence of relative luminance difference between gray-scale gradations 1 and 2, 2 and 3, 3 and 4 and 4 and 5, respectively. As is apparent from Fig. 1, when the conventional TN mode liquid crystal display is observed at about 20°, the relative luminance difference of curve 34 is 0 and it is understood that the gray-scale inversion GS occurs such that the display quality markedly deteriorates from the downward direction.

U.S. Patent No. 6,342,939 to Hirata et al., the entirety of which is hereby incorporated by reference, discloses a liquid crystal display with improved viewing characteristics, comprising a pair of opposing transparent substrates with a liquid crystal layer interposed therebetween. A transparent electrode is formed on the liquid crystal layer side of each of the substrates. The opposing transparent electrodes disposed in pairs have two or more different cell gaps at least within one display area of a pixel.

U.S. Patent Application Publication No. 2002/0105614 to Nakayama et al., the entirety of which is hereby incorporated by reference, discloses an array substrate of a liquid crystal display. In the array substrate, a second pixel electrode is disposed in a layer above an insulating layer which is itself disposed in a layer above a first pixel electrode. The second pixel electrode is electrically connected to the first pixel electrode and has a region that does not overlap the first pixel electrode, improving viewing angle characteristics.

US Patent Application Publication No. 2004/00974766 to Lee et al., discloses an active matrix liquid display with a first substrate and a second substrate with a liquid crystal layer interposed therebetween, wherein a first pixel electrode and a first pixel driving device formed on part of the first substrate and a second pixel electrode and a second pixel driving device formed on part of the first substrate are electrically connected, respectively, and wherein a common electrode formed on an interior of the second substrate is provided.

A similar configuration of an active matrix liquid display is, e.g., disclosed in European Patent Application No. 0 438 138, in which the display is divided into a plurality of display electrodes each defining one pixel, wherein the electrodes are consisting of electrically connected first and second segments, wherein a common electrode is provided and a layer of liquid crystal is interposed between the common electrode and the segments, respectively.

The publication Sarma K.R. et al. "Active-Martix LCDs Using Gray-Scale in Halftone Methods" discloses a liquid crystal display comprising a plurality of pixel areas with a first and a second substrate disposed opposite each other with a liquid crystal layer interposed therebetween and a first and a second pixel electrode and a first and a second pixel driving device formed on part of the first substrate, wherein the first and second pixel electrodes are electrically connected to the first and second pixel driving device, respectively, and
a common electrode formed on an interior of the second substrate; wherein the first and second pixel driving devices have mutually different ON currents, causing the first pixel electrode and the second pixel electrode to have mutually different voltages to enable a voltage drop. This document discloses the features of the preamble of claim 1.

According to the invention, a liquid crystal display according to claim 1 is provided. Preferred developements are defined in the dependent claims.

## SUMMARY

Liquid crystal displays with improved gray-scale (or viewing angle characteristics) are provided. An exemplary embodiment of a liquid crystal display comprises a plurality of pixel areas, each comprising a first substrate and a second substrate disposed opposite each other with a liquid crystal layer interposed therebetween. A first pixel electrode and a first pixel driving device are formed on part of the first substrate, wherein the first pixel electrode is electrically connected to the first pixel driving device. A second pixel electrode and a second pixel driving device are formed on part of the first substrate, wherein the second pixel electrode is electrically connected to the second pixel driving device. A common electrode is formed on an interior of the second substrate. The first and second pixel driving devices have mutually different ON currents ($I_{on}$), resulting in the first and second pixel electrodes having mutually different voltages.

Another exemplary embodiment of a liquid crystal display comprises a plurality of pixel areas, each comprising a transversely extending gate line and a longitudinally extending source line formed on a first substrate. A thin film transistor is disposed in a vicinity of an intersection of the gate line and the source line, wherein the thin film transistor comprises a first drain and a second drain. A first pixel electrode with a first area is electrically connected to the source line via the first drain to cause the first pixel electrode having a first voltage. A second pixel electrode with a second area is electrically connected to the source line via the second drain, causing the second pixel electrode to have a second voltage. A voltage drop occurs between the first and second voltages. A second substrate opposite the first substrate is provided. A common electrode is formed on the interior of the second substrate. A liquid crystal layer is interposed between the first substrate and the second substrate.

Further, the embodiments of the first and second pixel driving devices can be two thin film transistors comprising the same gate, the same channel layer, the same source and two different drains (i.e. a first drain and a second drain).

Each pixel area of the liquid crystal comprises a first pixel electrode and a second pixel electrode having mutually different voltages. The first and second pixel electrodes are respectively electrically connected to the first and second pixel driving devices having mutually different ON currents, causing the liquid crystal layer comprising two liquid crystal orientation areas having mutually different orientation directions. The angle at which the gray-scale inversion occurs is thus widened downward, improving viewing angle characteristics.

Further scope of applicability of embodiments of the disclosure will become apparent from the detailed description given hereinafter. It should be understood that the detailed description and specific examples are given by way of illustration only, since various changes and modifications within the spirit and scope of the disclosure will become apparent to those skilled in the art from this detailed description.

## DESCRIPTION OF THE DRAWINGS

Liquid crystal displays with improved gray-scale can be more fully understood by reading the subsequent detailed description in conjunction with the examples and references made to the accompanying drawings, wherein:

Fig. 1 shows viewing-angle dependence of relative luminance difference in the normally white mode for a conventional TN mode liquid crystal display in the downward direction;
Fig. 2 is a plan view of an embodiment of a pixel area in an array substrate of a first embodiment of a liquid crystal display;
Fig. 3 is a sectional view of the pixel area taken along line 3-3 of Fig. 2;
Fig. 4 is an enlarged diagram showing an embodiment of the configuration of first and second thin film transistors;
Fig. 5 is a graph depicting an embodiment of the operation of the first and second thin film transistors;
Fig. 6 is a sectional view of the first embodiment of the liquid crystal display;
Fig. 7 is a graphical plot of the relationship between the ratio of A1/(A1+A2) and the angle when gray-scale inversion occurs in an embodiment of a liquid crystal display, wherein A1 is the area of a first pixel electrode and A2 is the area of a second pixel electrode;
Fig. 8 is an explanatory RC circuit diagram for calculating the voltage of each pixel electrode of the first embodiment of the liquid crystal display; and
Fig. 9 is a plan view of an embodiment of a pixel area of a second embodiment of a liquid crystal display.

## DETAILED DESCRIPTION

### First Embodiment

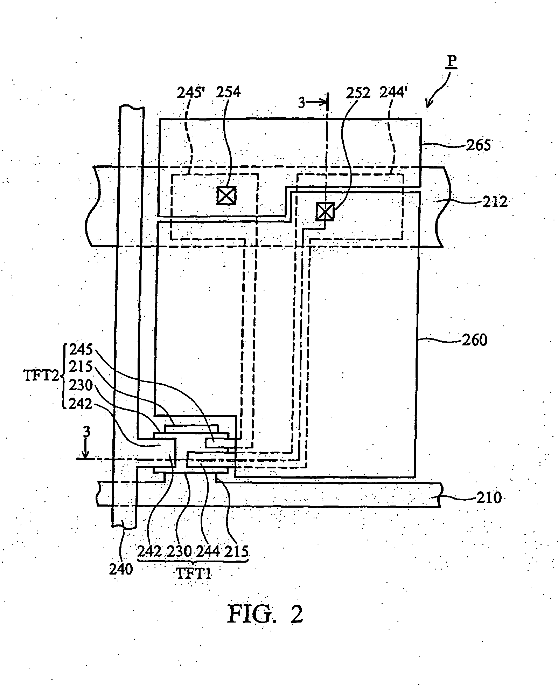

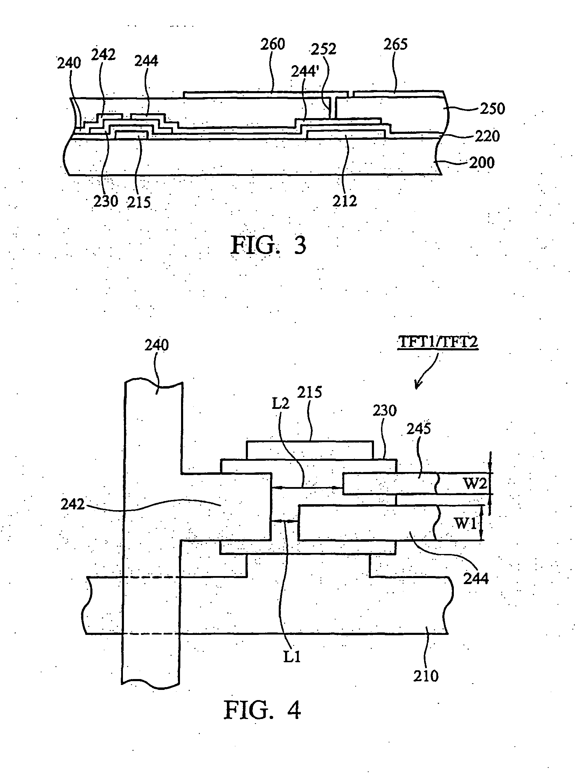

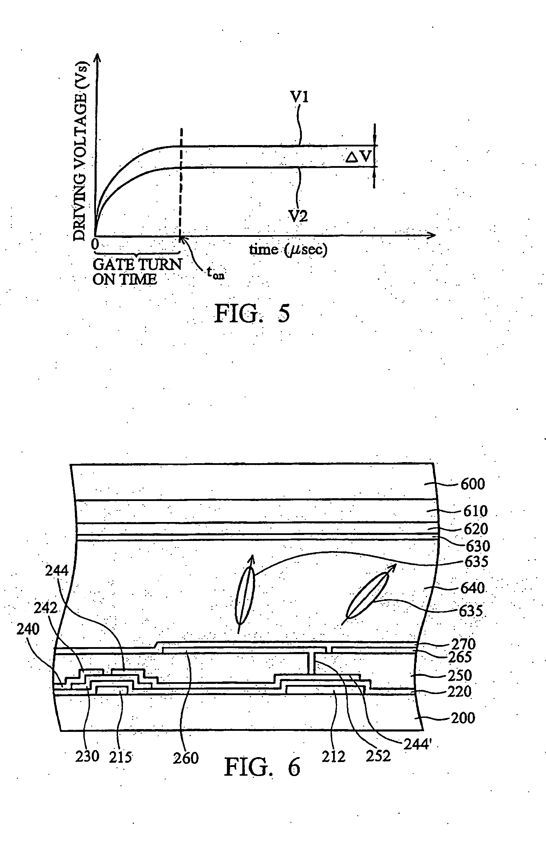

Fig. 2 is a plan view of an embodiment of a pixel area in an array substrate of the first embodiment of a liquid crystal display. Fig. 3 is a sectional view of the pixel area P taken along line 3-3 of Fig. 2. Fig. 6 is a sectional view of the liquid crystal display comprising an array substrate, opposing substrate and liquid crystal interposed therebetween. In Fig. 2, the liquid crystal display comprises a plurality of pixel areas P arranged in an array matrix. The pixel areas P are defined by crossing gate and source (or data) lines 210 and 240. In order to simplify the illustration, Figs. 2 and 6 show one pixel area P, although there may be numerous pixel areas P.

In Figs. 2 and 3, a transversely extending gate line 210 and a transversely extending storage capacitance electrode line 212 (hereinafter referred to as Cs line) are disposed on part of a first substrate 200. The first substrate 200, serving as a lower substrate 200, can be glass or quartz. The gate line 210 comprises a protrusion serving as a gate 215. The gate line 210 and the Cs line 212 can comprise A1, Cr, Mo or other conductive material. The gate line 210 and the Cs line 212 can be simultaneously formed by the same deposition. A gate insulating layer 220 then thoroughly overlies the first substrate 200. The gate insulating layer 220 can be $SiO_2$ formed by, for example, deposition.

A semiconductor layer 230, serving as a channel layer 230, overlies part of the gate insulating layer 220. The channel layer 230 can be silicon formed by, for example, deposition.

A longitudinally extending source line 240 is disposed on part of the gate insulating layer 220. The source line 240 comprises a source 242 extended onto part of the channel layer 230. A first drain 244 and a second drain 245 are disposed on part of the channel layer 230 and the gate insulating layer 220. The first drain 244 comprises a first extending portion 244' overlapped with part of the Cs line 212. The second drain 245 comprises a second extending portion 245' overlapped with part of the Cs line. The source line 240, the source 242 and the drains 244 and 245 can comprise Al, Cr, Mo or other conductive material. The source line 240, the source 242 and the drains 244 and 245 can be simultaneously formed by the same deposition procedure. Thus, the gate 215, the gate insulating layer 220, the channel layer 230, the source 242 and the first drain 244 constitute a first thin film transistor (TFT1) serving as a first pixel driving device. The gate 215, the gate insulating layer 220, the channel layer 230, the source 242 and the second drain 245 constitute a second thin film transistor (TFT2) serving as a first pixel driving device. The thin film transistors TFT1 and TFT2 serve as switching elements to apply electric charges/discharges to the pixel electrodes described in the following. It is noted that the thin film transistors TFT1 and TFT2 have mutually different ON currents ($I_{on}$).

Although in this instance the thin film transistors TFT1 and TFT2 share the same gate 215, the same channel layer 230 and the same source 242, the thin film transistors TFT1 and TFT2 can also be two independent devices with two different gates, channel layers, sources and drains. In order to avoid obscuring aspects of the disclosure, formation of the two independent thin film transistors is not described here.

An insulating layer 250 thoroughly overlies the first substrate 200. The insulating layer 250 can be organic or inorganic formed by, for example, deposition or coating. By performing photolithography and etching on the insulating layer 250, a first hole 252 exposing the first extending portion 244' and a second hole 254 exposing the second extending portion 245' are formed. A first pixel electrode 260 with a first area (A1) and a second pixel electrode 265 with a second area (A2) are then defined on the insulating layer 250. The first pixel electrode 260 fills the first hole 252 to electrically connect the first drain 244 and the second pixel electrode 265 fills the second hole 254 to electrically connect the second drain 245 simultaneously. Since thin film transistors TFT1 and TFT2 have mutually different ON currents ($I_{on}$), the first pixel electrode 260 has a first voltage (V1) and the second pixel electrode has a second voltage (V2). Note that a voltage drop ($\Delta V$) occurs between the first voltage (V1) and the second voltage (V2).

Figs. 4 and 5 are used to explain the first and second pixel electrodes 260 and 265 having mutually different voltages. Fig. 4 is an enlarged diagram showing an embodiment of the configuration of first and second thin film transistors TFT1 and TFT2. Fig. 5 is a graph for explaining the operation of first and second thin film transistors TFT1 and TFT2. Referring to Fig. 4, the first drain 244 has a first width (W1), the second drain 245 has a second width (W2), a first interval (L1) exists between the first drain 244 and the source 242 and a second interval (L2) exists between the second drain 245 and the source 242. It is noted that a relationship between W1, W2, L1 and L2 satisfies W1/L1≠W2/L2, causing thin film transistors TFT1 and TFT2 having mutually different ON currents ($I_{on}$). Referring to Fig. 5, when the source line 240 applies a driving voltage (Vs) to the thin film transistors TFT1 and TFT2 and the gate turn on time ($t_{on}$) of the gate 215 is set to about 10~30μsec, a voltage drop ($\Delta V$) occurs between the charged pixel electrodes 260 and 265 due to the thin film transistors TFT1 and TFT2 having mutually different ON currents ($I_{on}$).

In Fig. 6, an alignment film 270 is disposed on the pixel electrodes 260 and 265 and the insulating layer 250. A second substrate 600 is provided opposite the first substrate 200. The second substrate 600 can be a glass substrate comprising a color filter 610 formed thereon. A common electrode 620 is disposed on the interior of the color filter 610. The common electrode 620 can be ITO or IZO formed by, for example, deposition. Another alignment film 630 is disposed on the common electrode 620.

A liquid crystal material, such as TN (twisted nematic) type liquid crystal molecules 635, is then filled in a space between the first substrate 200 and the second substrate 600, constituting a liquid crystal layer 640. The thickness of the liquid crystal layer 640 is about 2~10μm, preferably, 5μm. Since the first voltage (V1) of the first pixel electrode 260 is different from the second voltage (V2) of the second pixel electrode 265, the liquid crystal molecules 635 have different orientation directions (shown by arrows) above the first and second pixel electrodes 260 and 265. That is, the liquid crystal layer 635 comprises two liquid crystal orientation areas having mutually different orientation directions. Thus, the gray-scale inversion (or viewing angle characteristics) is improved.

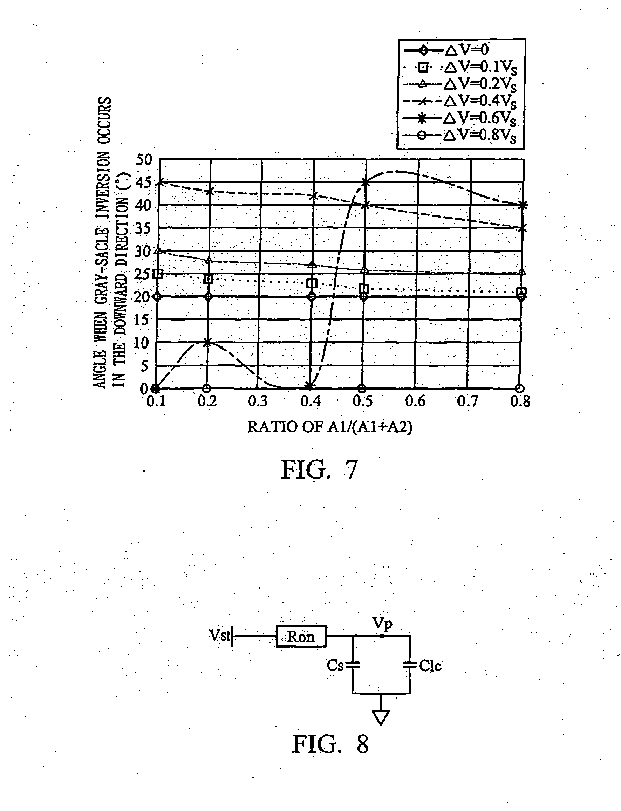

Fig. 7 is a graphical plot of the relationship between the ratio of the area (A1) of the first pixel electrode 260 to the total area (A1+A2) of the first and second pixel electrodes 260, 265 and the angle when gray-scale inversion occurs in a downward direction. In Fig. 7, the testing conditions are set to various voltage drops ($\Delta V$=0, 0.1Vs, 0.2Vs, 0.4Vs, 0.6Vs and 0.8Vs) between the first and second pixel electrodes 260 and 265. When the voltage drop ($\Delta V$) of the present liquid crystal display satisfies 0<$\Delta V$<0.6Vs, the angle at which gray-scale inversion occurs is greater than 20° under the 0<A1/(A1+A2)<0.8 condition. Additionally, when the voltage drop ($\Delta V$) of the present liquid crystal display is 0.6Vs, the angle at which gray-scale inversion occurs is greater than 20° under the 0.45<A1/(A1+A2)<0.8 condition. This verifies that the angle at which the gray-scale inversion occurs is widened downwards in comparison to the conventional TN mode liquid crystal display.

A demonstrative test of the first embodiment is described here, but it is not intended to limit the disclosure. In this test, a TN mode liquid crystal display with scanning frequency of 75Hz and resolution of 1024×768 is employed. Referring to Figs. 4 and 5, the ratio of W1/L1 of the first thin film transistor TFT1 is set at 3, the ratio of W2/L2 of the second thin film transistor TFT2 is set at 0.889, the gate turn on time ($t_{on}$) of the gate 215 is set at 10μsec and the driving voltage (Vs) provided from the source line 240 is set at 5V. Thus, the charging ratio (CR1) of the first pixel electrode 260 electrically connected to the first thin film transistor TFT1 achieves about 99.36%. The charging ratio (CR2) of the second pixel electrode 265 electrically connected to the second thin film transistor TFT2 achieves about 76.71%. The calculation of the test is as follows.

The driving operation of the pixel of the liquid crystal display can be referred to as a RC circuit, as shown as Fig. 8. After the gate turn on time ($t_{on}$), the voltage (Vp) of the pixel electrode is as expressed by Equation (1) below. The charging ratio (CR) is as expressed by Equation (2) below. The ON resistance (Ron) of the thin film transistor is as expressed by Equation (3) below.

$$Vp = Vs\left(1 - e^{\frac{-t_{on}}{Ron(C_{LC}+C_{CS})}}\right) \qquad (1)$$

$$CR = Vp/Vs = \left(1 - e^{\frac{-t_{on}}{Ron(C_{LC}+C_{CS})}}\right) \qquad (2)$$

$$Ron = V_{SD}/I_{on} = \frac{V_{SD}}{\frac{1}{2}\frac{W}{L}C_{OX}(Vgh-Vth)^2} \qquad (3)$$

The following testing parameters are used for calculating the test. The liquid crystal capacitance ($C_{LC}$) is 0.4298E-12F. The storage capacitance ($C_{CS}$) is 0.1896E-12F. The potential difference ($V_{SD}$) between the source and the drain is 10V (i.e. the inverse polarity potential between the source and the drain is $\pm$5V). The field effect mobility ($\mu$) of the thin film transistor is 0.35E-4m²/V. The capacitance ($C_{OX}$) per unit surface area of a gate insulating film is 1.49E-4F/m². When a thin film transistor is in the ON state, the highest gate voltage (Vgh) is 22V. The threshold voltage (Vth) of the thin film transistor is 2V.

Regarding the first thin film transistor TFT1, since the ratio of W1/L1 is 3, the ON resistance (Ron) of the thin film transistor is 3.2E6Ω and the charging ratio (CR1) of the first pixel electrode 260 is 99.36%. Regarding the second thin film transistor TFT2, since the ratio of W2/L2 is 0.889, the ON resistance (Ron) of the thin film transistor is 11.08E6Ω and the charging ratio (CR2) of the second pixel electrode 265 is 76.71%. Thus, the voltage drop ($\Delta$V) between the first pixel electrode 260 and the second pixel electrode 265 is 1.1V.

## The voltage drop (ΔV)

= (CR1-CR2)*Vs

= 22.65%*5V

= 1.1V

As shown in Fig. 7, when the voltage drop ($\Delta$V) is 0.2Vs, the angle when gray-scale inversion occurs is greater than 25°. Accordingly, the test verifies that an embodiment of the liquid crystal display has improved gray-scale and wider viewing angle.

**Second Embodiment**

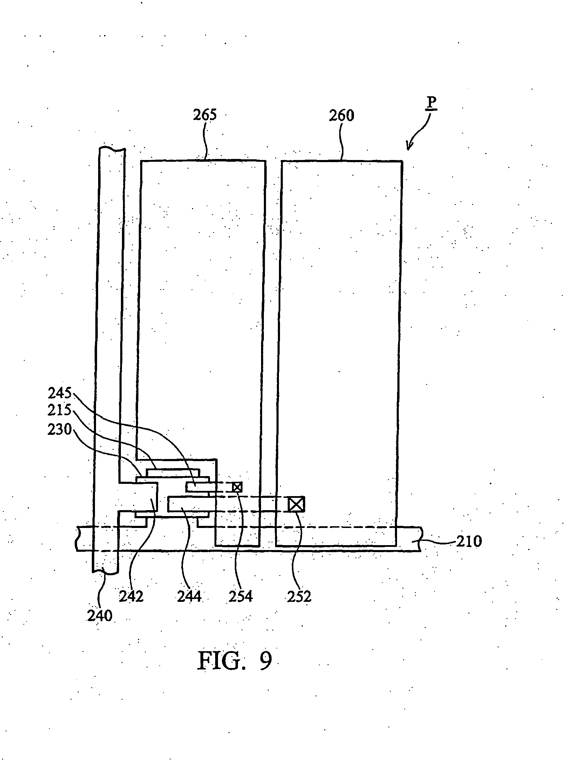

Fig. 9 is a plan view of a pixel area P of the second embodiment of a liquid crystal display. In this embodiment, part of the pixel electrodes 260 and 265 overlap the gate line 210 rather than the Cs line 212 overlies the first substrate 200. Aperture ratio of the pixel area P is thus increased. Since formation of the liquid crystal display of the second embodiment is similar to the first embodiment, description of detailed formation thereof is omitted here.

**Claims**

1. A liquid crystal display comprising a plurality of pixel areas (P), each comprising:

a first substrate (200) and a second substrate (600) disposed opposite each other with a liquid crystal layer (640) interposed therebetween;
a first pixel electrode (260) and a first pixel driving device (215,220,230,242,244) formed on part of the first substrate (200), wherein the first pixel electrode (260) is electrically connected to the first pixel driving device (215,220,230,242,244);
a second pixel electrode (265) and a second pixel driving device (215,220,230,242,245) formed on part of the first substrate (200), wherein the second pixel electrode (265) is electrically connected to the second pixel driving device (215,220,230,242,245);
a common electrode (620) formed on an interior of the second substrate (600); and
a gate line (210) and a source line (240) formed on the first substrate (200) perpendicular to the gate line (210), wherein the first pixel driving device (215,220,230,242,244) is a first thin film transistor (TFT1) disposed in the vicinity of an intersection of the gate line (210) and the source line (240) and which comprises a first drain (244), wherein the second pixel driving device comprises a second drain (245), wherein the first pixel electrode (260) with a first area A1 is electrically connected to the source line (240) via the first drain (244) to cause the first pixel electrode (260) to have a first voltage (V1) and the second pixel electrode (265) with a second area A2 is electrically connected to the source line (240) via the second drain (245) to cause the second pixel electrode (265) to have a second voltage (V2), and wherein the first pixel driving device (215,220,230,242,244) and the second pixel driving device (215,220,230,242,245) have mutually different ON currents ($I_{on}$), causing the first pixel electrode (260) and the second pixel electrode (265) to have mutually different voltages (Vp) to enable a voltage drop $\Delta V$ between the first and second voltages (V1,V2),
**characterized in that**
the source line (240) is adapted to apply a driving voltage Vs to the thin film transistor (TFT1), and $0<\Delta V<0.6Vs$ and the relationship between the areas A1 and A2 satisfies $0<A1/(A1+A2)<0.8$ or $\Delta V$ is equal to 0.6Vs and the relationship between the areas A1 and A2 satisfies $0.45<A1/(A1+A2)<0.8$.

2. Liquid crystal display according to claim 1, wherein the second pixel driving device (215,220,230,242,245) is a second thin film transistor (TFT2).

3. Liquid crystal display according to claim 1 or 2, wherein the liquid crystal layer (640) comprises two liquid crystal orientation areas having mutually different orientation directions.

4. Liquid crystal display according to one of claims 1 to 3, wherein the liquid crystal layer (640) comprises twisted nematic-type liquid crystal molecules (635).

5. Liquid crystal display according to one of claims 1 to 4, wherein the first and second pixel electrodes (260,265) are indium tin oxide (ITO) or indium zinc oxide (IZO) layers.

6. Liquid crystal display according to one of claims 1 to 5, wherein the common electrode (620) is an indium tin oxide (ITO) or indium zinc oxide (IZO) layer.

7. Liquid crystal display according to claim 2, wherein the first and second thin film transistors (TFT1,TFT2) comprise the same gate (215), the same channel layer (230) and the same source (242).

8. Liquid crystal display according to claim 7, wherein the first thin film transistor (TFT1) comprises the first drain (244) and the second thin film transistor (TFT2) comprises the second drain (245).

9. Liquid crystal display according to claim 1 or 8, wherein the first drain (244) has a first width W1, the second drain (245) has a second width W2, a first interval L1 exists between the first drain (244) and the source (242), a second interval L2 exists between the second drain (245) and the source (242) and a relationship between W1, W2, L1 and L2 satisfies $W1/L1 \neq W2/L2$.

10. Liquid crystal display according to one of claims 1 to 10, further comprising a storage capacitance electrode line (212) formed on part of the first substrate (200).

**EP 1 674 925 B1**

**Patentansprüche**

1. Flüssigkristallanzeige mit mehreren Pixelbereichen (P), die jeweils aufweisen:

ein erstes Substrat (200) und ein zweites Substrat (600), die einander gegenüberliegend angeordnet sind, wobei eine Flüssigkristallschicht (640) zwischen diesen eingefügt ist,
eine erste Pixelelektrode (260) und eine erste Pixelansteuervorrichtung (215, 220, 230, 242, 244), die auf einem Abschnitt des ersten Substrats (200) ausgebildet sind, wobei die erste Pixelelektrode (260) elektrisch mit der ersten Pixelansteuervorrichtung (215, 220, 230, 242, 244) verbunden ist,
eine zweite Pixelelektrode (265) und eine zweite Pixelansteuervorrichtung (215, 220, 230, 242, 245), die auf einem Abschnitt des ersten Substrats (200) ausgebildet sind, wobei die zweite Pixelelektrode (265) elektrisch mit der zweiten Pixelansteuervorrichtung (215, 220, 230, 242, 245) verbunden ist,
eine gemeinsame Elektrode (620), die innen liegend auf dem zweiten Substrat (600) ausgebildet ist, und
eine Gate-Leitung (210) und eine Quellleitung (240), die auf dem ersten Substrat (200) senkrecht zu der Gate-Leitung (210) ausgebildet ist, wobei die erste Pixelansteuervorrichtung (215, 220, 230, 242, 244) ein erster Dünnfilmtransistor (TFT1) ist, der in der Nähe einer Kreuzung der Gate-Leitung (210) und der Quellleitung (240) angeordnet ist und der eine erste Senke (244) aufweist, wobei die zweite Pixelansteuervorrichtung eine zweite Senke (245) aufweist, wobei die erste Pixelelektrode (260) mit einem ersten Bereich A1 elektrisch mit der Quellleitung (240) über die erste Senke (244) verbunden ist, um zu bewirken, dass die erste Pixelelektrode (260) eine erste Spannung (V1) aufweist, und wobei die zweite Pixelelektrode (265) mit einem zweiten Bereich A2 elektrisch mit der Quellleitung (240) über die zweite Senke (245) verbunden ist, um zu bewirken, dass die zweite Pixelelektrode (265) eine zweite Spannung (V2) aufweist, und wobei die erste Pixelansteuervorrichtung (215, 220, 230, 242, 244) und die zweite Pixelansteuervorrichtung (215, 220, 230, 242, 245) gegenseitig unterschiedliche ON-Ströme ($I_{on}$) aufweisen, was bewirkt, dass die erste Pixelelektrode (260) und die zweite Pixelelektrode (265) gegenseitig unterschiedliche Spannungen (Vp) aufweisen, so dass ein Spannungsabfall $\Delta V$ zwischen der ersten und der zweiten Spannung (V1, V2) ermöglicht wird, **dadurch gekennzeichnet, dass** die Quellleitung (240) eingerichtet ist, um eine Steuerspannung Vs auf den Dünnfilmtransistor (TFT1) zu übertragen, und dass $0 < \Delta V < 0,6$ Vs ist und die Beziehung zwischen den Bereichen A1 und A2 die Bedingung $0 < A1/(A1+A2) < 0,8$ erfüllt oder dass $\Delta V$ gleich 0,6 Vs ist und das Verhältnis zwischen den Bereichen A1 und A2 die Bedingung $0,45 < A1/(A1+A2) < 0,8$ erfüllt.

2. Flüssigkristallanzeige nach Anspruch 1, bei welcher die zweite Pixelansteuervorrichtung (215, 220, 230, 242, 245) ein zweiter Dünnfilmtransistor (TFT2) ist.

3. Flüssigkristallanzeige nach Anspruch 1 oder 2, bei welcher die Flüssigkristallschicht (640) zwei Flüssigkristallausrichtungsbereiche aufweist, die wechselseitig unterschiedliche Orientierungsrichtungen aufweisen.

4. Flüssigkristallanzeige nach einem der Ansprüche 1 bis 3, bei welcher die Flüssigkristallschicht (640) gedrehte, nematische Flüssigkristallmoleküle (635) aufweist.

5. Flüssigkristallanzeige nach einem der Ansprüche 1 bis 4, bei welcher die erste und die zweite Pixelelektrode (260, 265) eine Indium-Zinn-Oxid (ITO)- oder eine Indium-Zink-Oxid (IZO)-Schicht ist.

6. Flüssigkristallanzeige nach einem der Ansprüche 1 bis 5, bei welcher die gemeinsame Elektrode (620) eine Indium-Zinn-Oxid (ITO)- oder eine Indium-Zink-Oxid (IZO)-Schicht ist.

7. Flüssigkristallanzeige nach Anspruch 2, bei welcher der erste und der zweite Dünnfilmtransistor (TFT1, TFT2) das gleiche Gate (250), die gleiche Kanalschicht (230) und die gleiche Quelle (242) aufweisen.

8. Flüssigkristallanzeige nach Anspruch 7, bei welcher der erste Dünnfilmtransistor (TFT1) eine erste Senke (244) und der zweite Dünnfilmtransistor (TFT2) eine zweite Senke (245) aufweist.

9. Flüssigkristallanzeige nach Anspruch 1 oder 8, bei welcher die erste Senke (244) eine erste Breite W1 und die zweite Senke (245) eine zweite Breite W2 aufweist, wobei ein erstes Intervall L1 zwischen der ersten Senke (244) und der Quelle (242) und ein zweites Intervall L2 zwischen der zweiten Senke (245) und der Quelle (242) besteht und wobei eine Verhältnis zwischen W1, W2, L1 und L2 die Bedingung $W1/L1 \neq W2/L2$ erfüllt.

10. Flüssigkristallanzeige nach einem der Ansprüche 1 bis 10, weiter aufweisend eine Speicherkapazität-Elektrodenleitung (212), die auf einem Abschnitt des ersten Substrats (200) ausgebildet ist.

**Revendications**

1. Un affichage à cristaux liquides comprenant une pluralité de zones de pixels (P), comprenant chacune :

un premier substrat (200) et un deuxième substrat (600), disposés face à face, avec une couche de cristal liquide (640) placée entre ;
une première électrode pixel (260) et un premier dispositif d'entraînement de pixels (215,220,230,242,244) formé sur une partie du premier substrat (200), dans lequel la première électrode pixel (260) est branchée électriquement au premier dispositif d'entraînement de pixels (215,220,230,242,244) ;
une deuxième électrode pixel (265) et un deuxième dispositif d'entraînement de pixels (215,220, 230,242,245) formé sur une partie du premier substrat (200), dans lequel la deuxième électrode pixel est branchée électriquement au deuxième dispositif d'entraînement de pixels (215,220,230,242,245) ;
une électrode commune (620) formée sur l'intérieur du deuxième substrat (600) ; et
une ligne de grille (210) et une ligne source (240) formée sur le premier substrat (200) perpendiculaire à la ligne de grille (210), dans lequel le premier dispositif d'entraînement de pixels (215, 220, 230, 242, 244) est un transistor à couche mince (TCM1) disposé à proximité d'une intersection de la ligne de grille (210) et de la ligne source (240), et qui comprend un premier drain (244) dans lequel le dispositif d'entraînement du deuxième pixel comporte un deuxième drain (245), dans lequel la première électrode pixel (260) avec une première zone A1, est branchée électriquement à la ligne source (240) via le premier drain (244) pour que la première électrode pixel (260) reçoive une première tension (V1) et la deuxième électrode pixel (265) avec une deuxième zone A2 est connectée électriquement à la ligne source (240) via le deuxième drain (245) pour que la deuxième électrode pixel (265) reçoive une deuxième tension (V2), et dans lequel le premier dispositif d'entraînement de pixels (215, 220, 230, 242, 244) et le deuxième dispositif d'entraînement de pixels (215, 220, 230, 242, 245) possèdent mutuellement des courants ON (Ion), qui font que la première électrode pixel (260) et la deuxième électrode pixel (265) reçoivent mutuellement des tensions différentes (Vp) afin de permettre une baisse de tension $\Delta V$ entre la première et la deuxième tension (V1,V2), **caractérisées en ce que** la ligne source (240) est adaptée pour appliquer une tension de polarisation dynamique Va sur le transistor à couche mince (TFT1) et $0 < \Delta V < 0{,}6 Vs$ et la relation entre les zones correspond à $0 < A1/(A1+A2) < 0{,}8$ ou $\Delta V$ équivaut à 0,6 Vs et la relation entre les zones A1 et A2 correspond à $0{,}45 < A1/(A1+A2) < 0{,}8$.

2. Affichage à cristaux liquides selon la revendication 1, dans lequel le deuxième dispositif d'entraînement de pixels (215, 220, 230, 242, 245) est un deuxième transistor à couche mince (TCM2).

3. Affichage à cristaux liquides selon la revendication 1 ou 2, dans lequel la couche de cristal liquide (640) comprend deux zones d'orientation de cristal liquide ayant mutuellement des directions d'orientation différentes.

4. Affichage à cristaux liquides selon une des revendications allant de 1 à 3, dans lequel la couche de cristal liquide (640) comprend des molécules de cristal liquide de type nématique en hélice.

5. Affichage à cristaux liquides selon une des revendications allant de 1 à 4, dans lequel la première et la deuxième électrode pixel (260, 265) sont des couches en oxyde d'indium-étain ou en oxyde d'indium-zinc.

6. Affichage à cristaux liquides selon une des revendications allant de 1 à 5, dans l'électrode commune est une couche en oxyde d'indium-étain ou en oxyde d'indium-zinc.

7. Affichage à cristaux liquides selon la revendication 2, dans lequel le premier et le deuxième transistor à couche mince (TCM1, TCM2) comporte la même grille (215), la même couche de transmission (230) et le même source (242).

8. Affichage à cristaux liquides selon la revendication 7, dans lequel le premier transistor à couche mince (TCM1) comporte le premier drain (244) et le deuxième transistor à couche mince (TCM2) comporte le deuxième drain (245).

9. Affichage à cristaux liquides selon les revendications allant de 1 à 8, dans lequel le premier drain (244) possède une première largeur W1, le deuxième drain possède une deuxième largeur, un premier intervalle existe entre le premier drain (244) et le source (242), un deuxième intervalle L2 existe entre le deuxième drain (245) et le source (242) et une relation entre W1, W2, L1 et L2 correspond à W1/L1=W2/L2.

10. Affichage à cristaux liquides selon une des revendications allant de 1 à 10, comportant en outre une électrode ligne à capacité de stockage (212) formée sur une partie du premier substrat (200).

FIG. 1 (RELATED ART)

FIG. 2

240 242 244 260 252 244' 265

250

220

200

230 215 212

FIG. 3

240 TFT1/TFT2

L2 215 230 245

W2

242 W1

244

L1 210

FIG. 4

FIG. 5

FIG. 6

FIG. 7

FIG. 8

FIG. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6342939 B, Hirata
- US 20020105614 A, Nakayama
- US 200400974766 A, Lee
- EP 0438138 A

**Non-patent literature cited in the description**

- **SARMA K.R. et al.** *Active-Martix LCDs Using Gray-Scale in Halftone Methods*